(19) **Europäisches Patentamt**
**European Patent Office**
**Office européen des brevets**

(11) **EP 2 239 588 B1**

(12) **EUROPEAN PATENT SPECIFICATION**

(45) Date of publication and mention
of the grant of the patent:
**30.11.2011 Bulletin 2011/48**

(51) Int Cl.:
*G01R 19/165* (2006.01)   *G01R 27/14* (2006.01)

(21) Application number: **09005278.8**

(22) Date of filing: **11.04.2009**

(54) **Voltage surveillance circuit**

Spannungsüberwachungsschaltung

Circuit de surveillance de tension

(84) Designated Contracting States:
**AT BE BG CH CY CZ DE DK EE ES FI FR GB GR HR HU IE IS IT LI LT LU LV MC MK MT NL NO PL PT RO SE SI SK TR**

(43) Date of publication of application:
**13.10.2010 Bulletin 2010/41**

(73) Proprietor: **Thales Deutschland GmbH**
**70435 Stuttgart (DE)**

(72) Inventor: **Lauterberg, Veit, Dr.**
**75242 Neuhausen (DE)**

(74) Representative: **Kohler Schmid Möbus**
**Patentanwälte**
**Ruppmannstraße 27**
**70565 Stuttgart (DE)**

(56) References cited:
**DE-A1- 2 352 495     DE-U1- 29 721 675**
**JP-A- 4 276 564**

**Description**

Background of the Invention

The invention relates to a voltage surveillance circuit for detecting deviations of an input voltage from a pre-defined voltage window, and to a safety-critical system comprising at least one such voltage surveillance circuit.

In safety-critical systems, for example in railway systems, it is mandatory check if a monitored voltage, e.g. a supply voltage, is comprised in a given voltage window (tolerance window) between a lower threshold voltage and an upper threshold voltage. In case that the monitored voltage deviates from the given voltage window, i.e. raises above the upper threshold voltage or falls below the lower threshold voltage, such a deviation may be detected and appropriate countermeasures may be initiated. An implementation of a voltage monitoring circuit using a window comparator can be found in JP-A-04276564.

Also in safety-critical systems, it is mandatory to perform a regular check of the functionality of the components of such a voltage surveillance circuit in order to detect failures in its components which may cause the surveillance circuit to give an erroneous indication that that the monitored voltage is in the voltage tolerance window.

As yet, voltage surveillance circuits have been known which use at least two A/D-converters with fixed internal conversion characteristics, e.g. resistor-networks (direct conversion) or fixed timing (slope conversion). However, providing A/D-converters typically requires high expenditures which are undesired especially for standalone systems. Moreover, with such circuits, failure detection always requires additional design efforts.

Object of the Invention

It is an object of the invention to provide a voltage surveillance circuit for detecting deviations of an input voltage from a pre-defined voltage window allowing a failure detection of the components of the circuit.

Summary of the Invention

This object is achieved by a voltage surveillance circuit comprising: a first and a second comparator for comparing the input voltage or a voltage derived from the input voltage to an upper and to a lower threshold voltage, a reference voltage divider comprising a plurality of resistors arranged in series for deriving the first and the second threshold voltage from a reference voltage, a first and second switch adapted to bridge a respective one of the resistors of the voltage divider, and a switching unit for switching either the first or the second switch to a closed state to detect failures in the voltage surveillance circuit.

According to the invention, it is proposed to operate the voltage surveillance circuit in three different operational modes: in a first (normal) mode, the two switches are in an open state the input voltage is checked for conformity with the voltage tolerance window. In a first testing mode, the first switch is closed (the second switch still being pen), leading to a shift of the upper and the lower voltage threshold, the comparison of the input voltage to the shifted upper and lower threshold being used for detecting failures of specific components of the surveillance circuit. In a similar way, in a second testing mode, the second switch is closed (the first switch still being open), also causing a shift of the upper and lower voltage threshold (in the opposite direction), the comparison of the shifted upper and lower threshold voltage to the input voltage being again used for a failure detection of the components of the surveillance circuit. In all three cases, the output voltages of the two comparators can be used to reveal a deviation of the input voltage or a malfunction of the surveillance circuit, respectively. The circuit may be switched from the normal operation mode to one of the test operation modes in regular (periodic) intervals, the time required for the testing being relatively short, such that most of the time the circuit may be operated in the normal operation mode.

In one embodiment, the resistances of the voltage divider are selected such that when the first switch is in a closed state (first testing mode), the lower threshold voltage is larger than the upper threshold voltage when both switches are in the open state (normal mode). In such a way, provided that the input voltage is contained in the correct voltage interval during normal operation, a malfunction of the circuit can be detected when the output of the second comparator does not change after switching to the first testing mode.

In another embodiment, the resistances of the voltage divider are chosen so that when the second switch is in a closed state (second testing mode), the upper threshold voltage is lower than the lower threshold voltage when both switches are in the open state (normal mode). Also in this case, a malfunction of the circuit can be detected when the output of the first comparator does not change after switching to the second test operation mode.

Thus, when switching from normal operation mode to both testing modes alternately, malfunctions of the components, e.g. of the resistors of the reference voltage divider may be detected, as failures of those resistors typically shift both the upper and the lower threshold voltage into the same direction, such that the malfunction may be detected at the output of the comparators. It will be understood that malfunctions (short-circuits or breaks) of other components, e.g. of the comparators, may also be detected in the testing modes.

In one embodiment, the comparators are implemented as operational amplifiers. The operational amplifiers can be driven with a wide range of supply voltages. They also have the advantage of providing a binary result of the comparison of the voltage levels at their respective inputs which may be provided e.g. to logical switching circuits for further processing.

In a further embodiment, a first input of the first comparator to which the upper threshold voltage is provided and a second input of the second comparator to which the lower threshold voltage is provided are connected via a resistance of the reference voltage divider. The resistance is used for fixing the difference between the upper and the lower threshold voltage, corresponding to the allowed tolerance of the monitored voltage which is provided to the comparators, the monitored voltage either being the input voltage or a voltage derived therefrom.

In one development, the first input is a non-inverting input of the first comparator and the second input is an inverting input of the second comparator, the comparators being implemented as operational amplifiers in this case. The input voltage / the voltage derived from the input voltage is provided to the second (inverting) input of the first comparator and to the first (non-inverting) input of the second comparator.

In another embodiment, the resistors of the voltage divider which are to be bridged by the switches have identical resistance values. Dimensioning of the voltage surveillance circuit may be simplified by balancing the resistances of the voltage divider, for example by choosing the sum of the resistances defining the threshold voltage of the first comparator equal to the sum of the resistances defining the threshold voltage of the second comparator. In this case, when an identical resistance value is chosen for the resistors which are to be bridged, it is possible to have the nominal value of the input voltage, resp. of the voltage derived therefrom to be equal to half of the reference voltage.

In yet another embodiment, an input voltage divider for generating the derived voltage from the input voltage is provided. The further voltage divider allows one to generate a derived voltage from the input voltage, the derived voltage being adapted to the specific resistance values chosen for the resistors of the reference voltage divider. In particular, the input voltage divider may be implemented as a variable voltage divider (potentiometer), it not being necessary to modify the input voltage for performing the voltage monitoring in this case. It will be understood that it is also possible to implement the reference voltage divider as a variable voltage divider by using one or more potentiometers, although typically the reference voltage divider is implemented as a number of resistors with fixed values.

In one embodiment the first and/or the second switch are implemented as field effect transistors, allowing to perform fast switching between their open and closed states. It will be understood that the first and/or the second switch may also be implemented as mechanical switches, in particular as micro-electromechanical switches (MEMS). The switching unit which is provided for performing the switching typically is a computer program product implemented in a suitable software or hardware, in particular a field programmable gate array (FPGA) or an application-specific integrated circuit (ASIC). The same also applies to an evaluation circuit which may be provided to evaluate the voltage levels at the output of the comparators in order to indicate failures. It will be understood that the voltage surveillance circuit and the evaluation circuit may be implemented in the same or in separate hardware components.

A further aspect of the invention relates to a safety-critical system, in particular a railway system (e.g. an interlocking), comprising at least one voltage surveillance circuit as described above. The voltage surveillance circuit may be advantageously used in safety-critical systems as it allows both checking of deviations of the input voltage from a given voltage window and double-checking of the correct functionality of the circuit.

In one embodiment, the safety-critical system further comprises a power-supply, comprising: a power source for generating a supply voltage, and a voltage surveillance circuit as described above, the supply voltage being provided as an input voltage to the voltage surveillance circuit. Maintaining the correct value of a power supply is of particular importance, as a voltage drop of the power supply may lead to failures of the entire system which is fed by the supply voltage. Using the voltage surveillance circuit, an early detection of deviations of the supply voltage from its nominal level is possible, thus allowing to quickly take appropriate countermeasures, e.g. by switching to a redundant power supply for feeding the system. However, the person skilled in the art will appreciate that providing a power supply with a voltage surveillance circuit as described above may be advantageous in a wide variety of applications, the invention being by no means limited to safety-critical systems such as railway systems.

Further features and advantages are stated in the following description of exemplary embodiments, with reference to the figures of the drawing, which shows significant details, and are defined by the claims. The individual features can be implemented individually by themselves, or several of them can be implemented in any desired combination.

Brief Description of the Drawings

Exemplary embodiments are shown in the diagrammatic drawing and are explained in the description below. The following are shown:

**Fig. 1** shows a schematic diagram of an embodiment of the voltage surveillance circuit according to the invention, and

**Fig. 2** shows an example of the threshold voltages provided to a first and second comparator of the voltage surveillance circuit of Fig. 1 in three different operation modes.

Detailed Description of Preferred Embodiments

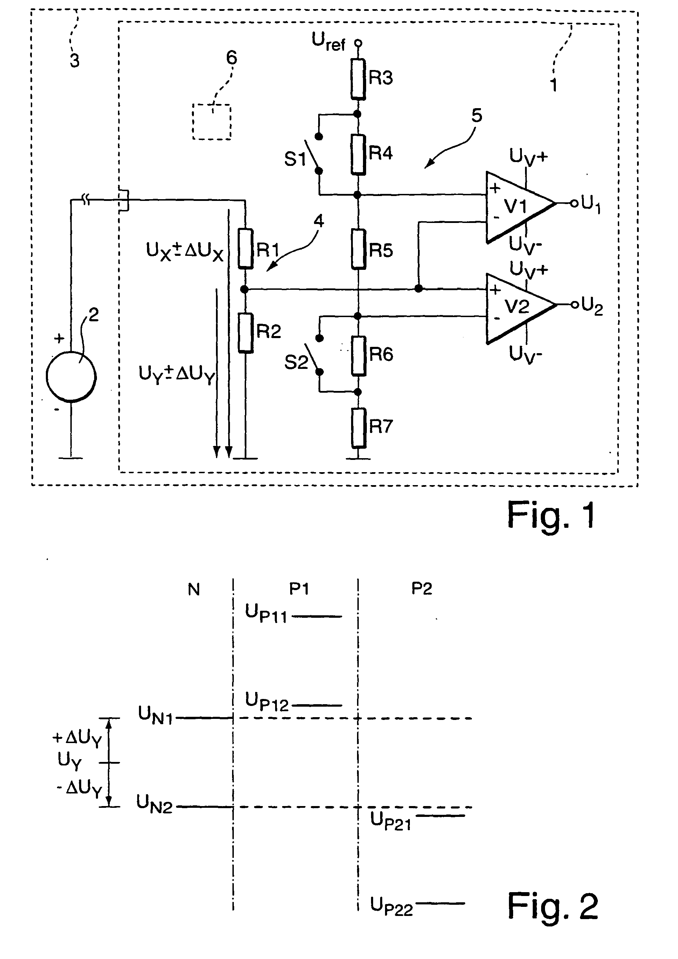

**Fig. 1** shows a voltage surveillance circuit **1** for monitoring an input voltage $U_x$ provided to the voltage surveillance circuit 1 from a power source **2** which is used for feeding further components (not shown) of a safety-critical system **3**, e.g. of a railway control center / interlocking. The input voltage $U_x$ may deviate from its nominal value by an amount $\Delta U_x$ which is chosen such that a correct functionality of the components fed by the power source 2 can be guaranteed.

Thus, the voltage surveillance circuit 1 is used to check if the input voltage $U_x$ deviates from the tolerated voltage window defined by $U_{min} = U_x - \Delta U_x$ and $U_{max} = U_x + \Delta U_x$. For this purpose, the voltage surveillance circuit 1 comprises an input voltage divider **4** comprising a first and a second resistor **R1**, **R2** arranged in series for generating a derived voltage $U_y$ from the input voltage $U_x$. The derived voltage $U_y$ is fed to an inverting fist input of a first comparator **V1** implemented as an operational amplifier and to a non-inverting second input of a second comparator **V2** also being implemented as an operational amplifier. Furthermore, a reference voltage divider 5 is provided in the voltage surveillance circuit 1, the reference voltage divider 5 comprising five resistors **R3** to **R7** arranged in series and providing an upper and a lower threshold voltage $U_{N1}$, $U_{N2}$ derived from a reference voltage $U_{ref}$ to the first (non-inverting) input of the first comparator V1 and to the second (inverting) input of the second comparator V2. The first input of the first comparator V1 and the second input of the second comparator V2 are connected via a fifth resistance R5 of the reference voltage divider, a third and fourth resistor R3, R4 being arranged between the reference voltage $U_{ref}$ and the first input of the first comparator V1, a sixth and seventh resistor R6, R7 being arranged between the second input of the second comparator V2 and ground.

For checking if the input voltage $U_x$ deviates from the pre-defined voltage window, the first comparator V1 compares the derived voltage $U_y$ to the upper threshold voltage $U_{N1}$, the second comparator V2 comparing the derived voltage $U_y$ to the lower threshold voltage $U_{N2}$. As usual with operational amplifiers, the result of the comparison can be detected as a binary output voltage $U_1$, $U_2$ at the output of the comparators V1, V2 corresponding either to the upper or the lower supply voltage $U_{v+}$, $U_{v-}$ of the comparators V1, V2 (typically: $U_{v-} = 0$).

In the present case, the input voltage $U_x$ is contained in the desired voltage window when the first and the second output voltage of the comparators V1, V2 is $U_1 = U_{v+1}$ $U_2 = U_{v+}$. A deviation from the tolerated interval can be detected when one of the output voltages $U_1$, $U_2$ changes its value to $Uv_-$.

In the preceding sections, the voltage surveillance circuit 1 has been described in its normal operation state, i.e. when inspection of the input voltage $U_x$ is performed. For checking the correct functionality of the voltage surveillance circuit 1, the latter further comprises a first and a second switch **S1**, **S2** arranged in parallel to the forth resistor R4 and the sixth resistor R6, respectively, and a switching unit **6** for switching either the first or the second switch S1, S2 from an open to a closed state (bridging the respective resistor R4, R6). When switching the first or second switch S1, S2 from the open to the closed state, the voltage surveillance circuit 1 is switched from its normal operation mode **N** to a first, resp. second testing mode **P1**, **P2**, cf. **Fig. 2**.

The reference voltage divider **5** is designed such that when bridging the fourth resistor R4 with the first switch S1 to switch from normal mode N in the first testing mode P1, the lower threshold voltage $U_{P12}$ is higher than the upper threshold voltage $U_{N1}$ when the voltage surveillance circuit 1 is operated in normal mode N, provided that the voltage surveillance circuit 1 operates correctly. Thus, when the output voltage $U_2$ of the second comparator V2 does not change from $U_2 = U_{v+}$ in normal operation mode N to $U_2 = U_{v-}$ in the first testing mode P1, this is a clear indication that at least one of the components of the circuit 1 does not operate correctly.

In a similar way, the reference voltage divider 5 is designed such that when bridging the sixth resistor R6 with the second switch S2 to change from normal mode N to the second testing mode P2, the upper threshold voltage $U_{P21}$ falls below the lower threshold voltage $U_{N1}$ in normal operation mode N. Thus, an indication for a malfunction of the circuit 1 is given when the output voltage $U_1$ of the first comparator V1 does not change from $U_1 = U_{v+}$ in normal operation mode N to $U_1 = U_{v-}$ in the second testing mode P2.

The switching unit 6 which may be implemented e.g. as a FPGA or ASIC may switch in regular intervals from the normal operation mode N to the first and second testing modes P1, P2, thus providing a quasi-continuous check of the correct functionality of the voltage surveillance circuit 1. It will be understood that the time intervals in which the circuit 1 is operated in the testing modes **P1**, P2 may be chosen very small (e.g. less than 2 % of the time interval in normal mode N), such that a quasi-continuous surveillance of the input voltage $U_x$ can be maintained. For performing a rapid switching between the operation modes, the first and second switch S1, S2 may be implemented e.g. as a field effect transistor or as a micro-electromechanical switch (MEMS).

In the following, a table is provided which allows one to attribute failures of the voltage surveillance circuit 5 to the different components shown in Fig. 1:

| Input | Type of failure | Manifestation |
|---|---|---|
| $U_x$ | Overvoltage | U1 = Uv- |
| | Subvoltge | U2 = Uv- |
| Component | Type of failure | Manifestation |
| R1 | Short-circuit, value reduction | U1 = Uv- |
| | Break, value increases | U2 = Uv- |
| R2 | Short-circuit, value reduction | U2 = Uv- |
| | Break, value increases | U1 = Uv- |
| R3 | Short-circuit, value reduction | U2 = Uv- |
| | Break, value increases | U1 = Uv- |
| R4 | Short-circuit, value reduction | U2 = Uv- |
| | Break, value increases | U1 = Uv- |
| R5 | Short-circuit, value reduction | Reduction of voltage tolerance window |
| | Break, value increases | No reaction in both test modes P1 and P2 |
| R6 | Short-circuit, value reduction | U1 = Uv- |
| | Break, value increases | U2 = Uv- |
| R7 | Short-circuit, value reduction | U1 = Uv- |
| | Break, value increases | U2 = Uv- |
| S1 | Permanently open | No reaction in test mode P1 |
| | Permanently closed | U2 = Uv- |
| S2 | Permanently open | No reaction in test mode P2 |
| | Permanently closed | U2 = Uv- |
| V1 | Permanently low | U1 = Uv- |
| | Permanently high | No reaction in test mode P2 |
| | Oscillates | U1 = Uv- or no reaction in test mode P2 |
| V2 | Permanently low | U2 = Uv- |
| | Permanently high | No reaction in test mode P1 |
| | Oscillates | U2 = Uv- or no reaction in test mode P1 |
| Uref | Value reduction | U1 = Uv- |
| | Value increase | U2 = Uv- |
| Uy | Value reduction | U2 = Uv- or no reaction in any of the test modes P1 and P2 |
| | Value increase | U1 = Uv- or no reaction in any of the test modes P1 and P2 |

Finally, in the following, the correct dimensioning of the reference voltage divider 5 will be described in greater detail. For the sake of simplicity, in the following, the resistors will be identified with their respective resistance values.
It will be understood that the smaller the resistance R5 is in relation to the sum of the resistances R3 + R4, resp. R6 + R7, the smaller is the tolerance window:

$$U_{min} = U_x - \Delta U_x \qquad\qquad (1)$$

$$U_{max} = U_x + \Delta U_x \qquad (2)$$

The voltage at the inputs of the comparators V1, V2 is given by

$$U_y \pm \Delta U_y = (U_x \pm \Delta U_x) \, R1/(R1 + R2) \qquad (3)$$

In normal operation mode N, the threshold voltages $U_{N1}$, $U_{N2}$ are:

$$U_{N1} = U_{ref} (R5 + R6 + R7) / (R3 + R4 + R5 + R6 + R7) \qquad (4)$$

$$U_{N2} = U_{ref} (R6 + R7) / (R3 + R4 + R5 + R6 + R7) \qquad (5)$$

Taking into consideration the voltage drop at the reference voltage divider 5 and the overall resistance R of the reference voltage divider 5:

$$R = R3 + R4 + R5 + R6 + R7, \qquad (6)$$

it follows:

$$2 \, \Delta U_y / U_{ref} = R5 / R, \text{ resp.} \qquad (7)$$

$$R5 = 2 R \, \Delta U_y / U_{ref} \qquad (8)$$

In the first testing mode P1 (short-circuit of R4) the threshold voltages at the inputs of the comparators V1, V2 are:

$$U_{P11} = U_{ref} (R5 + R6 + R7) / (R - R4) \qquad (9)$$

$$U_{P12} = U_{ref} (R5 + R6) / (R - R4) \qquad (10)$$

Moreover, for enabling correct operation in the first testing mode P1 when the maximum tolerable input voltage $U_x + \Delta U_x$ is provided to the circuit 1, the output voltage $U_2$ of the second comparator V2 must be $U_2 = U_{v-}$. i.e. the following condition should be satisfied:

$$U_{P12} > U_y + \Delta U_y. \tag{11}$$

Moreover, in the second test mode P2 (short-circuit of R6) the following threshold voltages are provided to the comparators V1, V2, respectively:

$$U_{P21} = U_{ref} (R5 + R7) / (R - R6) \tag{12}$$

$$U_{P22} = U_{ref} R7 / (R - R6) \tag{13}$$

Moreover, similar to the first testing mode P1, also in the second testing mode P2 the following relation should be satisfied for a correct functionality of the testing:

$$U_{P21} < U_y - \Delta U_y \tag{14}$$

The dimensioning of the reference voltage divider 5 may be simplified considerably provided that

$$U_y \approx U_{ref} / 2 . \tag{15}$$

By balancing, one may then assume R3+R4 = R6 +R7, and, by inserting (10) in (11) the following simplification can be made:

$$U_y + \Delta U_y < U_{ref} (R3 +R4) / (R - R4) \tag{16}$$

Using (6) it follows:

$$U_y + \Delta U_y < U_{ref} (R- R5) /(2 (R - R4)). \tag{17}$$

Solving the above inequality for R4 one obtains:

$$R4 > R - U_{ref}(R - R5) /(2(U_y + \Delta U_y)) \tag{18}$$

In an analogous way, by inserting (12) into (14) and solving for R6, it follows:

$$R6 > (R(U_y - \Delta U_y) - \tfrac{1}{2} U_{ref} (R + R5)) / (U_y - \Delta U_y - U_{ref}), \qquad (19)$$

wherein $U_y - \Delta Uy - U_{ref} < 0$.

If one assumes $U_y = U_{ref}/2$, it follows R4 = R6.

As a concrete dimensioning example, when providing an input voltage $U_x = 5$ V and a voltage tolerance of $\Delta U_x = 0,125$ V and choosing R1 = 3000 Ω, $R_2$ = 2000 Ω, R = 4000 Ω, $U_{ref}$ = 4 V, it follows (after rounding) R5 = 100 Ω, R4 = R6 = 200 Ω, and finally R3 = R7 = 1750 Ω.

In summary, the voltage surveillance circuit described above provides an easy way for combining voltage surveillance with failure detection. Moreover, the circuit only comprises a few electrical components and is thus very cost-effective. Also, the circuit can be adapted easily to a wide range of input voltages / voltage tolerance levels by appropriately selecting the resistance values of the resistors. Moreover, as the voltage surveillance circuit described above may be integrated, it may be used for the surveillance of voltages in a variety of technical fields, not being limited to safety-critical applications.

**Claims**

1. Voltage surveillance circuit (1) for detecting deviations of an input voltage ($U_x$) from a pre-defined voltage window ($U_x - \Delta U_x$, $U_x + \Delta U_x$),
   the voltage surveillance circuit (1) comprising:

   a first and a second comparator (V1, V2) for comparing the input voltage ($U_x$) or a voltage ($U_y$) derived from the input voltage ($U_x$) to an upper and to a lower threshold voltage ($U_{N1}$, $U_{N2}$; $U_{P11}$, $U_{P12}$; $U_{P21}$, $U_{P22}$), and
   a reference voltage divider (5) comprising a plurality of resistors (R3 to R7) arranged in series for deriving the first and the second threshold voltage ($U_{N1}$, $U_{N2}$ $U_{P11}$, $U_{P12}$; $U_{P21}$, $U_{P22}$) from a reference voltage ($U_{ref}$), **characterized by**
   a first and second switch (S1, S2) adapted to bridge a respective one of the resistors (R4, R6) of the reference voltage divider (5), and
   a switching unit (6) for switching the voltage surveillance circuit (1) between a normal operation mode (N) in which both the first and the second switch (S1, S2) are in an open state, a first testing mode (P1) in which the first switch (S1) is in a closed state and the second switch (S2) is in an open state, and a second testing mode (P2) in which the second switch (S2) is in a closed state and the first switch (S1) is in an open state, wherein in the first and second testing mode (P1, P2) the upper threshold voltage ($U_{P12}$, $U_{P12}$) and the lower threshold voltage ($U_{P2}$, $U_{P22}$) are shifted for detecting failures in the voltage surveillance circuit (1).

2. Voltage surveillance circuit according to claim 1, wherein the resistances (R3 to R7) of the voltage divider (5) are chosen such that when the first switch (S1) is in a closed state, the lower threshold voltage ($U_{P12}$) is larger than the upper threshold voltage ($U_{N1}$) when both switches (S1, S2) are in the open state.

3. Voltage surveillance circuit according to claim 1 or 2, wherein the resistances (R3 to R7) of the voltage divider (5) are chosen such that when the second switch (S2) is in a closed state the upper threshold voltage ($U_{P21}$) is lower than the lower threshold voltage ($U_{N2}$) when both switches (S1, S2) are in the open state.

4. Voltage surveillance circuit according to any one of the preceding claims, wherein the comparators (V1, V2) are implemented as operational amplifiers.

5. Voltage surveillance circuit according to any one of the preceding claims, wherein a first input of the first comparator (V1) to which the upper threshold voltage ($U_{N1}$, $U_{P11}$ $U_{P21}$) is provided and a second input of the second comparator (V2) to which the lower threshold voltage ($U_{N2}$, $U_{P21}$, $U_{P22}$) is provided are connected via a resistance (R5) of the reference voltage divider (5).

6. Voltage surveillance circuit according to claim 5, wherein the first input (+) is a non-inverting input of the first comparator (V1) and the second input (-) is an inverting input of the second comparator (V2).

7. Voltage surveillance circuit according to any one of the preceding claims, wherein the resistors (R4, R6) of the voltage divider (5) which are to be bridged by the switches (S1, S2) have identical resistance values.

8. Voltage surveillance circuit according to any one of the preceding claims, further comprising an input voltage divider (4) for generating the derived voltage ($U_y$) from the input voltage ($U_x$).

9. Voltage surveillance circuit according to any one of the preceding claims, wherein the first and/or the second switch (S1, S2) are implemented as field effect transistors.

10. Voltage surveillance circuit according to any one of the preceding claims, wherein the first and/or the second switch (S1, S2) are implemented as mechanical switches.

11. A safety-critical system (3), in particular a railway system, comprising at least one voltage surveillance circuit (1) according to any one of the preceding claims.

12. Safety-critical system according to claim 11, further comprising:

   a power source (2) for generating a supply voltage, the supply voltage being provided as an input voltage ($U_x$) to the voltage surveillance circuit (1).

**Patentansprüche**

1. Spannungsüberwachungsschaltung (1) zum Detektieren von Abweichungen einer Eingangsspannung ($U_x$) von einem vorgegebenen Spannungsfenster ($U_x - \Delta U_x$, $U_x + \Delta U_x$),
   wobei die Spannungsüberwachungsschaltung (1) umfasst:

   einen ersten und einen zweiten Komparator (V1, V2) zum Vergleichen der Eingangsspannung ($U_x$) oder einer Spannung ($U_y$), die von der Eingangsspannung ($U_x$) abgeleitet wird, mit einer oberen und einer unteren Schwellenspannung ($U_{N1}$, $U_{N2}$; $U_{P11}$, $U_{P12}$; $U_{P21}$, $U_{P22}$), und
   einen Referenzspannungsteiler (5), umfassend eine Mehrzahl an in Reihenschaltung angeordneten Widerständen (R3 bis R7) zum Ableiten der ersten und der zweiten Schwellenspannung ($U_{N1}$, $U_{N2}$ $U_{P11}$, $U_{P12}$; $U_{P21}$, $U_{P22}$) von einer Referenzspannung ($U_{ref}$),
   **gekennzeichnet durch**
   einen ersten und einen zweiten Schalter (S1, S2), die zum Überbrücken jeweils eines der Widerstände (R4, R6) des Referenzspannungsteilers (5) ausgestaltet sind, und
   eine Schalteinheit (6) zum Schalten der Spannungsüberwachungsschaltung (1) zwischen einem Normalbetrieb (N), bei dem sowohl der erste als auch der zweite Schalter (S1, S2) geöffnet sind, einem ersten Prüfbetrieb (P1), bei dem der erste Schalter (S1) geschlossen ist und der zweite Schalter (S2) geöffnet ist, und einem zweiten Prüfbetrieb (P2), bei dem der zweite Schalter (S2) geschlossen ist und der erste Schalter (S1) geöffnet ist, wobei beim ersten und zweiten Prüfbetrieb (P1, P2) die obere Schwellenspannung ($U_{P11}$, $U_{P12}$) und die untere Schwellenspannung ($U_{P21}$, $U_{P22}$) zum Detektieren von Fehlfunktionen der Spannungsüberwachungsschaltung (1) verschoben sind.

2. Spannungsüberwachungsschaltung nach Anspruch 1, wobei die Widerstände (R3 bis R7) des Spannungsteilers (5) derart gewählt sind, dass die untere Schwellenspannung ($U_{P12}$) bei Geschlossensein des ersten Schalters (S1) größer ist als die obere Schwellenspannung ($U_{N1}$) bei Geöffnetsein beider Schalter (S1, S2).

3. Spannungsüberwachungsschaltung nach Anspruch 1 oder 2, wobei die Widerstände (R3 bis R7) des Spannungsteilers (5) derart gewählt sind, dass die obere Schwellenspannung ($U_{P21}$) bei Geschlossensein des zweiten Schalters (S2) niedriger ist als die untere Schwellenspannung ($U_{N2}$) bei Geöffnetsein beider Schalter (S1, S2).

4. Spannungsüberwachungsschaltung nach einem der vorherigen Ansprüche, wobei die Komparatoren (V1, V2) als Operationsverstärker ausgeführt sind.

5. Spannungsüberwachungsschaltung nach einem der vorherigen Ansprüche, wobei ein erster Eingang des ersten Komparators (V1), an den die obere Schwellenspannung ($U_{N1}$, $U_{P11}$, $U_{P12}$) geliefert wird, und ein zweiter Eingang des zweiten Komparators (V2), an den die untere Schwellenspannung ($U_{N2}$, $U_{P21}$, $U_{P22}$) geliefert wird, über einen Widerstand (R5) des Referenzspannungsteilers (5) verbunden sind.

6. Spannungsüberwachungsschaltung nach Anspruch 5, wobei der erste Eingang (+) ein nichtinvertierender Eingang des ersten Komparators (V1) und der zweite Eingang (-) ein invertierender Eingang des zweiten Komparators (V2) ist.

7. Spannungsüberwachungsschaltung nach einem der vorherigen Ansprüche, wobei die Widerstände (R4, R6) des Spannungsteilers (5), die durch die Schalter (S1, S2) überbrückt werden müssen, identische Widerstandswerte aufweisen.

8. Spannungsüberwachungsschaltung nach einem der vorherigen Ansprüche, weiterhin umfassend einen Eingangsspannungsteiler (4) zum Erzeugen der von der Eingangsspannung ($U_x$) abgeleiteten Spannung ($U_y$).

9. Spannungsüberwachungsschaltung nach einem der vorherigen Ansprüche, wobei der erste und/oder der zweite Schalter (S1, S2) als Feldeffekttransistoren ausgeführt sind.

10. Spannungsüberwachungsschaltung nach einem der vorherigen Ansprüche, wobei der erste und/oder der zweite Schalter (S1, S2) als mechanische Schalter ausgeführt sind.

11. Sicherheitskritisches System (3), insbesondere ein Schienensystem, das zumindest eine Spannungsüberwachungsschaltung (1) nach einem der vorherigen Ansprüche umfasst.

12. Sicherheitskritisches System nach Anspruch 11, weiterhin umfassend:

    eine Stromquelle (2) zum Erzeugen einer Versorgungsspannung, wobei die Versorgungsspannung als Eingangsspannung ($U_x$) zur Spannungsüberwachungsschaltung (1) vorgesehen ist.

**Revendications**

1. Circuit de surveillance de tension (1) pour détecter les écarts d'une tension d'entrée ($U_x$) à partir d'une fenêtre de tension prédéfinie ($U_x - \Delta U_x$, $U_x + \Delta U_x$),
le circuit de surveillance de tension (1) comprenant :

    des premier et second comparateurs (V1, V2) pour comparer la tension d'entrée ($U_x$) ou une tension ($U_y$) dérivée de la tension d'entrée ($U_x$) à une tension de seuil supérieure et inférieure ($U_{N1}$, $U_{N2}$ ; $U_{P11}$, $U_{P12}$ ; $U_{P21}$, $U_{P22}$), et
    un diviseur de tension de référence (5) comprenant une pluralité de résistances (R3 à R7) agencées en série pour dériver la première et la seconde tension de seuil ($U_{N1}$, $U_{N2}$, $U_{P11}$, $U_{P12}$ ; $U_{P21}$, $U_{P22}$) d'une tension de référence ($U_{réf}$),
    **caractérisé par**
    des premier et second commutateurs (S1, S2) conçus pour ponter l'une des résistances respectives (R4, R6) du réducteur de tension de référence (5), et
    une unité de commutation (6) pour commuter le circuit de surveillance de tension (1) entre un mode de fonctionnement normal (N) dans lequel les premier et second commutateurs (S1, S2) sont tous deux dans un état ouvert, un premier mode d'essai (P1) dans lequel le premier commutateur (S1) est dans un état fermé et le second commutateur (S2) est dans un état ouvert, et un second mode d'essai (P2) dans lequel le second commutateur (S2) est dans un état fermé et le premier commutateur (S1) est dans un état ouvert, dans lequel dans les premier et second modes d'essai (P1, P2), la tension de seuil supérieure ($U_{P12}$, $U_{P12}$) et la tension de seuil inférieure ($U_{P21}$, $U_{P22}$) sont décalées pour détecter des défaillances dans le circuit de surveillance de tension (1).

2. Circuit de surveillance de tension selon la revendication 1, dans lequel les résistances (R3 à R7) du diviseur de tension (5) sont choisies de telle sorte que lorsque le premier commutateur (S1) est dans un état fermé, la tension de seuil inférieure ($U_{P12}$) est plus importante que la tension de seuil supérieure ($U_{N1}$) lorsque les deux commutateurs (S1, S2) sont dans l'état ouvert.

3. Circuit de surveillance de tension selon la revendication 1 ou 2, dans lequel les résistances (R3 à R7) du diviseur de tension (5) sont choisies de telle sorte que lorsque le second commutateur (S2) est dans un état fermé, la tension de seuil supérieure ($U_{P21}$) est inférieure à la tension de seuil inférieure ($U_{N2}$) lorsque les deux commutateurs (S1, S2) sont dans l'état ouvert.

4. Circuit de surveillance de tension selon l'une quelconque des revendications précédentes, dans lequel les comparateurs (V1, V2) sont mis en oeuvre en tant qu'amplificateurs opérationnels.

5. Circuit de surveillance de tension selon l'une quelconque des revendications précédentes, dans lequel une première entrée du premier comparateur (V1) à laquelle la tension de seuil supérieure ($U_{N1}$, $U_{P11}$, $U_{P21}$) est fournie et une seconde entrée du second comparateur (V2) à laquelle la tension de seuil inférieure ($U_{N2}$, $U_{P21}$, $U_{P22}$) est fournie sont connectées via une résistance (R5) du diviseur de tension de référence (5).

6. Circuit de surveillance de tension selon la revendication 5, dans lequel la première entrée (+) est une entrée non inverseuse du premier comparateur (V1) et la seconde entrée (-) est une entrée non inverseuse du second comparateur (V2).

7. Circuit de surveillance de tension selon l'une quelconque des revendications précédentes, dans lequel les résistances (R4, R6) du diviseur de tension (5) qui doivent être pontées par les commutateurs (S1, S2) ont des valeurs de résistance identiques.

8. Circuit de surveillance de tension selon l'une quelconque des revendications précédentes, comprenant en outre un diviseur de tension d'entrée (4) pour générer la tension dérivée ($U_y$) de la tension d'entrée ($U_x$).

9. Circuit de surveillance de tension selon l'une quelconque des revendications précédentes, dans lequel le premier et/ou le second commutateur(s) (S1, S2) sont mis en oeuvre en tant que transistors à effet de champ.

10. Circuit de surveillance de tension selon l'une quelconque des revendications précédentes, dans lequel le premier et/ou le second commutateur(s) (S1, S2) sont mis en oeuvre en tant que commutateurs mécaniques.

11. Système essentiel à la sécurité (3), en particulier d'un réseau ferroviaire, comprenant au moins un circuit de surveillance de tension (1) selon l'une quelconque des revendications précédentes.

12. Système essentiel à la sécurité selon la revendication 11, comprenant en outre :

une source d'énergie (2) pour générer une tension d'alimentation, la tension d'alimentation étant fournie sous forme d'une tension d'entrée ($U_x$) au circuit de surveillance de tension (1).

## Fig. 1

## Fig. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 04276564 A